# EUROPEAN PATENT SPECIFICATION

(11) **EP 4 325 581 B1**
(45) Date of publication and mention of the grant of the patent: **25.02.2026**
(21) Application number: 21944601.0
(22) Date of filing: 11.06.2021
(51) Int. Cl.: H10D 1/66, H10D 1/68, H10D 62/824, H10D 62/85, H10D 84/00, H10D 84/01, H10D 84/05, H01G 4/005, H01G 4/33, H01G 4/38

(54) **INTEGRATED DEVICE, SEMICONDUCTOR DEVICE, AND INTEGRATED DEVICE MANUFACTURING METHOD**
INTEGRIERTE VORRICHTUNG, HALBLEITERBAUELEMENT UND HERSTELLUNGSVERFAHREN FÜR DIE INTEGRIERTE VORRICHTUNG
DISPOSITIF INTÉGRÉ, DISPOSITIF À SEMI-CONDUCTEUR ET PROCÉDÉ DE FABRICATION DE DISPOSITIF INTÉGRÉ

(43) Date of publication of application: 21.02.2024
(73) Proprietor: Huawei Technologies Co., Ltd., Longgang Shenzhen, Guangdong 518129 (CN)
(72) Inventor: TANG, Gaofei, Shenzhen, Guangdong 518129 (CN); BAO, Qilong, Shenzhen, Guangdong 518129 (CN); WANG, Hanxing, Shenzhen, Guangdong 518129 (CN); JIANG, Qimeng, Shenzhen, Guangdong 518129 (CN); OUYANG, Dongfa, Shenzhen, Guangdong 518129 (CN)
(74) Representative: Pfenning, Meinig & Partner mbB
(86) International application number: PCT/CN2021/099575
(87) International publication number: WO 2022/257092

(56) References cited:
- CN-A- 103 730 450
- CN-A- 104 536 223
- CN-A- 104 795 428
- CN-A- 104 795 428
- CN-A- 111 344 774
- KR-A- 20060 072 752
- US-A1- 2009 057 828
- US-A1- 2009 218 578
- US-B1- 10 026 731

## Description

### TECHNICAL FIELD

This application relates to a microelectronic technology, and in particular, to an integrated device, a semiconductor device, and an integrated device manufacturing method.

### BACKGROUND

A gallium nitride (GaN) power device has great potential in the field of power conversion due to a small on-resistance and a fast turn-on speed of the gallium nitride power device. However, a spike voltage (10 V) that a gate of the device can bear is less than that of a conventional silicon device, and a threshold voltage is relatively small (between 1.0 V and 2.5 V). Therefore, in a fast turn-on process of the device, due to parasitic inductance on a board, oscillation easily occurs in a driving waveform of the gate of the device. As a result, the gate of the device is damaged by overvoltage, or the device is incorrectly turned on. To resolve this problem, a gate drive circuit and a single die may be monolithically integrated on a platform of a gallium nitride device.

Currently, on a single die process platform, a metal layer available in a process flow is usually used to form an electrode plate (such as a field plate layer or a gate metal layer) of a capacitor, and integration of the capacitor is limited by a chip area.

Because a thickness of a dielectric layer usually occupies a large area of the chip area, the integration of the capacitor is limited.

US 10026731 describes a compound semiconductor transistor integrated with a high density capacitor.

CN 104795428 describes an array substrate comprising a plurality of pixels, each of which includes a light emitting region and a non-light emitting region.

KR 2006 0072752 describes a Metal-Insulator-Metal capacitor and a method of manufacturing such a capacitor.

US 2009/218579 describes a capacitor with a lower electrode formed of a two-dimensional electron gas.

### SUMMARY

Embodiments of this application provide an integrated device, a semiconductor device, and an integrated device manufacturing method, to improve capacitor integration density of the integrated device. The scope of protection of the present invention is set out by the appended claims.

### BRIEF DESCRIPTION OF DRAWINGS

FIG. 1 is an architectural diagram of power amplification according to an embodiment of this application;
FIG. 2 is a schematic diagram of a structure of an integrated device according to an embodiment of this application;
FIG. 3 is a schematic diagram of an equivalent circuit diagram of an integrated device according to an embodiment of this application;
FIG. 4 is another schematic diagram of a structure of an integrated device according to an embodiment of this application;
FIG. 5 is another schematic diagram of an equivalent circuit diagram of an integrated device according to an embodiment of this application;
FIG. 6 is another schematic diagram of a structure of an integrated device according to an embodiment of this application;
FIG. 7 is another schematic diagram of an equivalent circuit diagram of an integrated device according to an embodiment of this application;
FIG. 8 is another schematic diagram of a structure of an integrated device according to an embodiment of this application;
FIG. 9 is another schematic diagram of an equivalent circuit diagram of an integrated device according to an embodiment of this application;
FIG. 10 is a schematic diagram of an embodiment of an integrated device manufacturing method according to an embodiment of this application;
FIG. 11 is a schematic diagram of another embodiment of an integrated device manufacturing method according to an embodiment of this application;
FIG. 12 is a schematic diagram of another embodiment of an integrated device manufacturing method according to an embodiment of this application;
FIG. 13 is a schematic diagram of another embodiment of an integrated device manufacturing method according to an embodiment of this application;
FIG. 14 is a schematic diagram of another embodiment of an integrated device manufacturing method according to an embodiment of this application;
FIG. 15 is a schematic diagram of a drive circuit according to an embodiment of this application; and
FIG. 16 is a schematic diagram of an electronic device according to an embodiment of this application.

### DESCRIPTION OF EMBODIMENTS

Embodiments of this application provide an integrated device, a semiconductor device, and an integrated device manufacturing method, to improve capacitor integration density of the integrated device.

The following describes embodiments of this application with reference to accompanying drawings. It is clear that the described embodiments are merely some but not all of embodiments of this application.

In the specification, the claims, and the accompanying drawings of this application, the terms "first", "second", and the like are intended to distinguish between similar objects but do not necessarily indicate a specific order or sequence. It should be understood that data termed in such a way is interchangeable in proper circumstances so that embodiments described herein can be implemented in other orders than the order illustrated or described herein. In addition, the terms "include" and "have" and any other variants are intended to cover non-exclusive inclusion. For example, a process, method, system, product, or device that includes a list of steps or units is not necessarily limited to those expressly listed steps or units, but may include other steps or units that are not expressly listed or that are inherent to such a process, method, product, or device.

In embodiments of this application, the "up" and "down" are described based on a process flow of a power device. When a "substrate" is used as a bottom surface, a direction that faces away from the "substrate" along a vertical path is "up", and a direction in which no other layers are disposed on the "substrate" along the vertical path is "down".

It should be understood that, for example, a related expression of "A is disposed on B" only indicates that A is located above B in a spatial sense, and does not limit a connection relationship between A and B. For example, when A is disposed on B, A may be in direct contact with B, or A may not be in direct contact with B. In this case, C may be included between A and B, where C may not completely separate A from B, or may completely separate A from B.

The following explains some key terms in embodiments of this application.

Gallium nitride (GaN): Gallium nitride (GaN) is a semiconductor with a wide bandgap, and belongs to a wide bandgap semiconductor. Gallium nitride is an excellent material for a microwave power transistor, and is a new semiconductor material for developing a microelectronic device and an optoelectronic device. Gallium nitride has a wide direct bandgap, a strong atomic bond, high thermal conductivity, good chemical stability (almost no acid corrosion), and strong radiation resistance.

Two-dimensional electron gas (Two-dimensional electron gas, 2DEG): A two-dimensional electron gas refers to a phenomenon that an electron gas can move freely in a two-dimensional direction, but is restricted in a third dimension. The two-dimensional electron gas is located between an aluminum gallium nitride layer and a gallium nitride layer in a gallium nitride device platform. The two-dimensional electron gas may also be referred to as a electron channel. The two-dimensional electron gas is a basis for operation of many field-effect devices (for example, a MOSFET and a HEMT).

A metal-insulator-metal (metal-insulator-metal, MIM) capacitor (also referred to as an inter-board capacitor) causes least interference to a transistor, and can provide good linearity (linearity) and symmetry (symmetry). Therefore, the metal-insulator-metal (metal-insulator-metal, MIM) capacitor has been widely used, especially in the field of mixed signals and radio frequency.

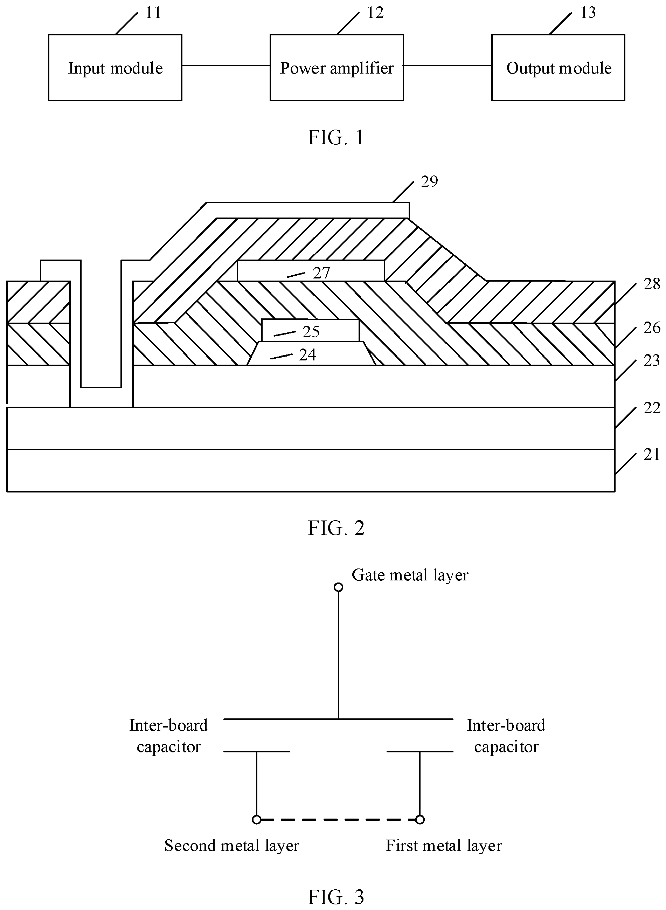

An integrated device in embodiments of this application may be applied to any scenario in which capacitor integration density is increased. A gallium nitride device is used as an example in embodiments of this application. FIG. 1 is an architectural diagram of power amplification according to an embodiment of this application. The architectural diagram includes an input module 11, a power amplifier 12, and an output module 13. The power amplifier 12 may amplify output power of the input module 11, and then output the output power to the output module 13. Power grid voltages vary greatly in countries around the world. For example, an alternating current voltage of a country A is 220 V, and is relatively stable. A power grid voltage of a country B fluctuates greatly, and ranges from 90 VAC to 350 VAC. Operating in a wide input voltage range needs larger capacity (at a low voltage) of an input filter capacitor and a higher withstand voltage rating (at a high voltage) of the input filter capacitor. To support a higher withstand voltage, capacitor manufacturers need to increase a size of a capacitor, resulting in a large increase of a volume of the capacitor. The gallium nitride (GaN) device may be used to increase switching frequency, to reduce a size of a transformer. To be specific, the power amplifier 12 is a gallium nitride (GaN) device, and the GaN device is a semiconductor device with larger bandwidth, a higher amplifier gain, higher energy efficiency, and a smaller size. Compared with other power amplifiers, due to a wide bandgap and high thermal conductivity of the GaN device, the GaN device can operate at a temperature above 200°C, and can bear higher energy density. Therefore, the GaN device has higher reliability. The wide bandgap and great insulation of the GaN device damage an electric field, so that an on-resistance of the device decreases. This helps improve overall energy efficiency of the device. Fast electron saturation and high carrier mobility of the GaN device allow the device to operate at a high speed.

Currently, on a single die process platform, a metal layer available in a process flow is usually used to form an electrode plate (such as a field plate layer and a gate metal layer) of a capacitor. Therefore, integration of the capacitor is limited by a thickness of a dielectric layer. However, the dielectric layer usually occupies a large part of a chip structure, and the integration of the capacitor is limited by a chip area.

To resolve the foregoing problem, embodiments of this application provide an integrated device. The following describes a structure of the integrated device.

FIG. 2 is a schematic diagram of the structure of the integrated device not according to an embodiment of the present invention. The integrated device includes a substrate 21, a gallium nitride (GaN) layer 22, an aluminum gallium nitride (AlGaN) layer 23, a P-type conductive layer 24, a first metal layer 25, a first dielectric layer 26, a gate metal layer 27, a second dielectric layer 28, and a second metal layer 29.

The substrate 21 may be made from a silicon (Si) substrate, a sapphire (Al2O3) substrate, a silicon-on-insulator (SOI) substrate, a gallium nitride (GaN) substrate, a gallium arsenide (GaAs) substrate, an indium phosphide (InP) substrate, an aluminum nitride (AlN) substrate, a silicon carbide (SiC) substrate, a quartz (SiO2) substrate, or a diamond (C) substrate.

The gallium nitride layer 22 is disposed on the substrate 21, and the gallium nitride layer 22 is preferably an undoped gallium nitride layer (if the gallium nitride layer 22 is a doped gallium nitride layer, magnesium Mg is used as a dopant).

The aluminum gallium nitride layer 23 is disposed on the gallium nitride layer 22, and the aluminum gallium nitride layer 23 is preferably an undoped aluminum gallium nitride layer.

The P-type conductive layer 24 is disposed on the aluminum gallium nitride layer 23, the P-type conductive layer 24 is located on an active area of the aluminum gallium nitride layer 23, and the P-type conductive layer 24 may be P-type gallium nitride or P-type aluminum gallium nitride. For example, the P-type conductive layer 24 is the P-type gallium nitride. The P-type gallium nitride may be a beryllium-doped gallium nitride layer, a zinc-doped gallium nitride layer, or a magnesium-doped gallium nitride layer.

The first metal layer 25 is disposed on the P-type conductive layer 24, and the first metal layer may preferably be made from titanium nitride (TiN) or tungsten (W). The titanium nitride is a transition metal nitride, includes a mix of an ionic bond, a metal bond, and a covalent bond, has high strength, high hardness, high temperature resistance, acid and alkali corrosion resistance, abrasion resistance, good conductivity, and good thermal conductivity, and is an excellent material for ohmic contact metal.

The first dielectric layer 26 is disposed on the first metal layer 25, and the first dielectric layer 26 covers the first metal layer 25, the P-type conductive layer 24, and the aluminum gallium nitride layer 23.

The gate metal layer 27 is disposed on the first dielectric layer 26, the second dielectric layer 28 is disposed on the gate metal layer 27, and the second metal layer 29 is disposed on the second dielectric layer 28.

The first dielectric layer 26 separates the gate metal layer 27 from the first metal layer 25, and the first metal layer 25 and the gate metal layer 27 have opposite polarities, so that the gate metal layer 27, the first dielectric layer 26, and the first metal layer 25 form a first capacitor (MIM). The second dielectric layer 28 separates the gate metal layer 27 from the second metal layer 29, and the second metal layer 29 and the gate metal layer 27 have opposite polarities, so that the gate metal layer 27, the second dielectric layer 28, and the second metal layer 29 form a second capacitor (MIM). When the first metal layer 25 is connected to the second metal layer 29 through a first conductor structure (not shown in the figure), a first terminal of the first capacitor is interconnected with a first terminal of the second capacitor, and a second terminal of the first capacitor is interconnected with a second terminal of the second capacitor. That is, the first capacitor and the second capacitor are connected in parallel. In this case, an equivalent circuit diagram of the integrated device may be shown in FIG. 3, and dashed lines in the circuit diagram indicate that polarities are the same. Alternatively, the first capacitor and the second capacitor may be connected in parallel in another connection manner, or the first capacitor and the second capacitor may be connected in series in another connection manner. This is not limited herein. In this embodiment of this application, the gate metal layer may be a positive electrode layer, and the second metal layer may be a negative electrode layer.

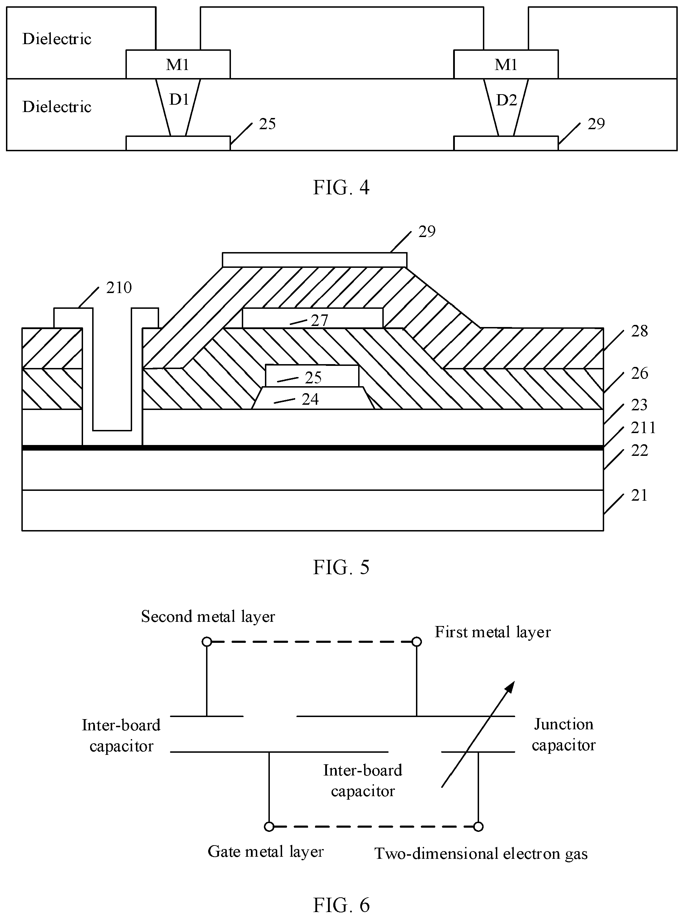

Specifically, for the first conductor structure, refer to FIG. 4. The first metal layer 25 is connected to metal M1 through a conductor D1 in an etching hole of the dielectric layer on the first metal layer 25, and the second metal layer 29 is connected to metal M1 through a conductor D2 in an etching hole of the dielectric layer on the second metal layer 29, where two pieces of metal M1 belong to a same piece of metal (not shown in the figure).

In this embodiment of this application, the first dielectric layer may separate the gate metal layer from the titanium nitride layer, the second dielectric layer separates the gate metal layer from the second metal layer, and the first metal layer is connected to the second metal layer through the first conductor structure, so that the first capacitor and the second capacitor are connected in parallel. This increases capacitor capacity of the integrated device, improves voltage withstand performance of the integrated device, and allows the integrated device to operate at a high voltage and have high capacitor density at the same time.

To implement higher capacitor density for an integrated device whose voltage range does not need to be limited, the present invention provides another schematic diagram of the structure of the integrated device shown in FIG. 5. The integrated device includes a substrate 21, a gallium nitride (GaN) layer 22, an aluminum gallium nitride (AlGaN) layer 23, a P-type conductive layer 24, a first metal layer 25, a first dielectric layer 26, a gate metal layer 27, a second dielectric layer 28, and a second metal layer 29.

The substrate 21 may be made from a silicon (Si) substrate, a sapphire (Al2O3) substrate, a silicon-on-insulator (SOI) substrate, a gallium nitride (GaN) substrate, a gallium arsenide (GaAs) substrate, an indium phosphide (InP) substrate, an aluminum nitride (AlN) substrate, a silicon carbide (SiC) substrate, a quartz (SiO2) substrate, or a diamond (C) substrate.

The gallium nitride layer 22 is disposed on the substrate 21, and the gallium nitride layer 22 is preferably an undoped gallium nitride layer (if the gallium nitride layer 22 is a doped gallium nitride layer, magnesium Mg is used as a dopant).

The aluminum gallium nitride layer 23 is disposed on the gallium nitride layer 22, and the aluminum gallium nitride layer 23 is preferably an undoped aluminum gallium nitride layer.

The P-type conductive layer 24 is disposed on the aluminum gallium nitride layer 23, the P-type conductive layer 24 is located on an active area of the aluminum gallium nitride layer 23, and the P-type conductive layer 24 may be P-type gallium nitride or P-type aluminum gallium nitride. For example, the P-type conductive layer 24 is the P-type gallium nitride. The P-type gallium nitride may be a beryllium-doped gallium nitride layer, a zinc-doped gallium nitride layer, or a magnesium-doped gallium nitride layer.

The first metal layer 25 is disposed on the P-type conductive layer 24, and the first metal layer may preferably be made from titanium nitride (TiN) or tungsten (W). The titanium nitride is a transition metal nitride, includes a mix of an ionic bond, a metal bond, and a covalent bond, has high strength, high hardness, high temperature resistance, acid and alkali corrosion resistance, abrasion resistance, good conductivity, and good thermal conductivity, and is an excellent material for ohmic contact metal.

The first dielectric layer 26 is disposed on the first metal layer 25, and the first dielectric layer 26 covers the first metal layer 25, the P-type conductive layer 24, and the aluminum gallium nitride layer 23.

The gate metal layer 27 is disposed on the first dielectric layer 26, the second dielectric layer 28 is disposed on the gate metal layer 27, and the second metal layer 29 is disposed on the second dielectric layer 28.

The integrated device further includes a third metal layer 210, the third metal layer 210 and the aluminum gallium nitride layer 23, where the third metal layer 210 further passes through the first dielectric layer 26, the second dielectric layer 28, and the aluminum gallium nitride layer 23, and is connected to the gallium nitride layer 22.

The first dielectric layer 26 separates the gate metal layer 27 from the first metal layer 25, and the first metal layer 25 and the gate metal layer 27 have opposite polarities, so that the gate metal layer 27, the first dielectric layer 26, and the first metal layer 25 form a first capacitor (MIM). The second dielectric layer 28 separates the gate metal layer 27 from the second metal layer 29, and the second metal layer 29 and the gate metal layer 27 have opposite polarities, so that the gate metal layer 27, the second dielectric layer 28, and the second metal layer 29 form a second capacitor (MIM). The first metal layer 25, the P-type conductive layer 24, and the two-dimensional electron gas 211 form a third capacitor (CJ), where the two-dimensional electron gas 211 is generated when a voltage between the gate metal layer 57 and the third metal layer 210 falls within a preset range, and a voltage usage range of a junction capacitor is 5 V to 7 V. The third metal layer 210 is in contact with the two-dimensional electron gas, and the third metal layer 210 and the first metal layer 25 have opposite polarities.

Optionally, an aluminum nitride layer is further included between the gallium nitride layer and the aluminum gallium nitride layer, and the two-dimensional electron gas is located between the aluminum nitride layer and the gallium nitride layer, so that electron concentration of the two-dimensional electron gas can be increased. When the first metal layer 25 is connected to the second metal layer 29 through a first conductor structure (not shown in the figure), and the third metal layer 210 is connected to the gate metal layer 27 through a second conductor structure (not shown in the figure), the first conductor structure and the second conductor structure may be copper or aluminum, a first terminal of the first capacitor, a first terminal of the second capacitor, and a first terminal of the third capacitor are interconnected, and a second terminal of the first capacitor, a second terminal of the second capacitor, and a second terminal of the third capacitor are interconnected. That is, the first capacitor, the second capacitor, and the third capacitor are connected in parallel. For an equivalent circuit diagram of the integrated device, refer to FIG. 6.

For a first conductor and a second conductor, refer to related descriptions of the first conductor in FIG. 4. The first metal layer 25 and the second metal layer 29 are separately connected to the metal M1, and the third metal layer 210 and the gate metal layer 27 are separately connected to the metal M2.

In this embodiment of this application, the first metal layer, the P-type conductive layer, and the two-dimensional electron gas corresponding to the third metal layer form the third capacitor, and the third metal layer is connected to the gate metal layer through the second conductor structure, so that the first capacitor, the second capacitor, and the third capacitor are connected in parallel. This increases capacitor capacity of the integrated device, improves voltage withstand performance of the integrated device, and further improves capacitor integration density of the integrated device.

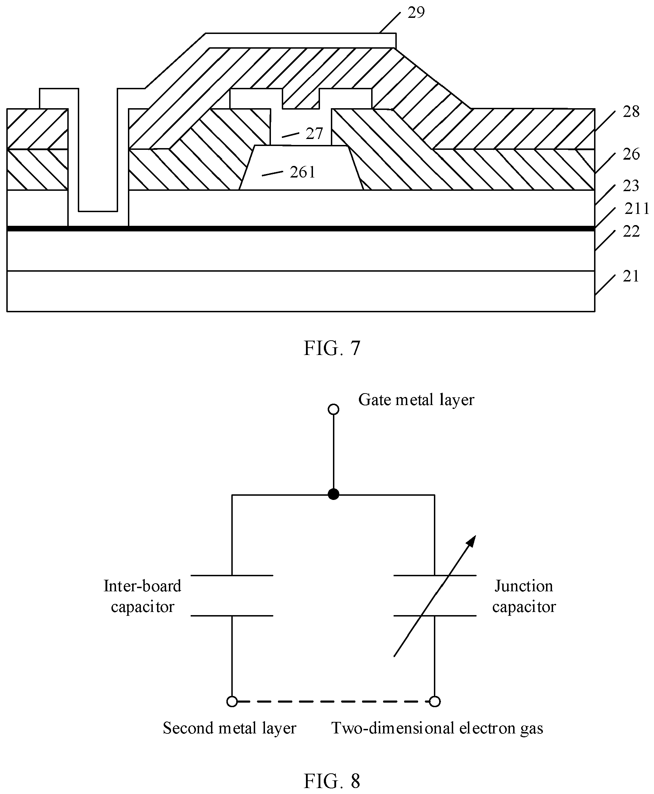

FIG. 7 is another schematic diagram of a structure of an integrated device according to an embodiment of the present invention. The integrated device includes a substrate 21, a gallium nitride (GaN) layer 22, an aluminum gallium nitride (AlGaN) layer 23, a first dielectric layer 26, a gate metal layer 27, a second dielectric layer 28, and a second metal layer 29.

The substrate 21 may be made from a silicon (Si) substrate, a sapphire (Al2O3) substrate, a silicon-on-insulator (SOI) substrate, a gallium nitride (GaN) substrate, a gallium arsenide (GaAs) substrate, an indium phosphide (InP) substrate, an aluminum nitride (AlN) substrate, a silicon carbide (SiC) substrate, a quartz (SiO2) substrate, or a diamond (C) substrate.

The gallium nitride layer 22 is disposed on the substrate 21, and the gallium nitride layer 22 is preferably an undoped gallium nitride layer (if the gallium nitride layer 22 is a doped gallium nitride layer, magnesium Mg is used as a dopant).

The aluminum gallium nitride layer 23 is disposed on the gallium nitride layer 22, and the aluminum gallium nitride layer 23 is preferably an undoped aluminum gallium nitride layer.

The first dielectric layer 26 is disposed on the aluminum gallium nitride layer 23, and the first dielectric layer 26 includes a fourth layer 261, where the fourth layer 261 is P-type gallium nitride or P-type aluminum gallium nitride, and the fourth layer 261 is located on an active area of the aluminum gallium nitride layer 23. For example, the fourth layer 261 is the P-type gallium nitride. The P-type gallium nitride may be a beryllium (Be)-doped gallium nitride layer, a zinc (Zn)-doped gallium nitride layer, or a magnesium (Mg)-doped gallium nitride layer. Optionally, the fourth layer may further include titanium nitride or tungsten, where the titanium nitride or the tungsten completely separates the P-type gallium nitride from the gate metal layer 27.

The gate metal layer 27 is disposed on the first dielectric layer 26, the second dielectric layer 28 is disposed on the gate metal layer 27, and the second metal layer 29 is disposed on the second dielectric layer 28. In this case, the fourth layer 261 is exposed by etching the first dielectric layer 26, and the gate metal layer 27 is formed on an etching hole formed by etching.

The first dielectric layer 26 separates the gate metal layer 27 from the aluminum gallium nitride layer 23, and a two-dimensional electron gas 211 below the aluminum gallium nitride layer 23 is connected to the second metal layer 29. The first dielectric layer includes the fourth layer 261, the fourth layer 261 may be the P-type gallium nitride or the P-type aluminum gallium nitride, and the second metal layer 29 and the gate metal layer 27 have opposite polarities, so that a first capacitor including the gate metal layer 27, the first dielectric layer 26, and the two-dimensional electron gas 211 is a junction capacitor (CJ). The second dielectric layer 28 separates the gate metal layer 27 from the second metal layer 29, and the second metal layer 29 and the gate metal layer 27 have opposite polarities, so that the gate metal layer 27, the second dielectric layer 28, and the second metal layer 29 form a second capacitor (MIM). The two-dimensional electron gas 211 is generated when a voltage between the gate metal layer 27 and the second metal layer 29 falls within a preset range, and a voltage usage range of a junction capacitor is 5 V to 7 V

Optionally, an aluminum nitride layer is further included between the gallium nitride layer and the aluminum gallium nitride layer, and the two-dimensional electron gas is located between the aluminum nitride layer and the gallium nitride layer, so that electron concentration of the two-dimensional electron gas can be increased. The second metal layer passes through the second dielectric layer 28, the first dielectric layer 26, and the aluminum gallium nitride layer 23, and is in contact with a two-dimensional electron gas 211. In this case, a first terminal of the first capacitor is connected to a first terminal of the second capacitor, and a second terminal of the first capacitor is connected to a second terminal of the second capacitor. That is, the first capacitor and the second capacitor are connected in parallel. For an equivalent circuit diagram of the integrated device, refer to FIG. 8. Alternatively, the first capacitor and the second capacitor may be connected in parallel in another connection manner, or the first capacitor and the second capacitor may be connected in series in another connection manner. This is not limited herein.

In this embodiment of this application, the gate metal layer may be a positive electrode layer, and the second metal layer may be a negative electrode layer. In this embodiment of this application, the gate metal layer, the first dielectric layer, and the two-dimensional electron gas form the first capacitor, the gate metal layer, the second dielectric layer, and the second metal layer form the second capacitor, and the two-dimensional electron gas is connected to the second metal layer, so that the first capacitor and the second capacitor are connected in parallel. This increases capacitor capacity of the integrated device, improves voltage withstand performance of the integrated device, and improves capacitor integration density of the integrated device.

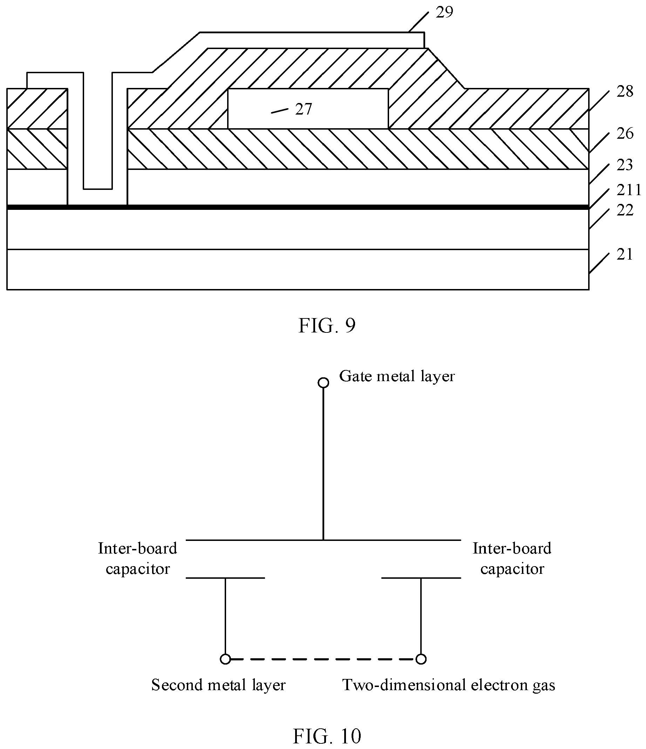

For a capacitor that is shown in FIG. 2 and that can be used in a high voltage and has high capacitor density, an embodiment not in accordance with the present invention further provides another schematic diagram of a structure of an integrated device shown in FIG. 9. The integrated device includes a substrate 21, a gallium nitride layer 22, an aluminum gallium nitride layer 23, a first dielectric layer 26, a gate metal layer 27, a second dielectric layer 28, and a second metal layer 29.

The substrate 21 may be made from a silicon (Si) substrate, a sapphire (Al2O3) substrate, a silicon-on-insulator (SOI) substrate, a gallium nitride (GaN) substrate, a gallium arsenide (GaAs) substrate, an indium phosphide (InP) substrate, an aluminum nitride (AlN) substrate, a silicon carbide (SiC) substrate, a quartz (SiO2) substrate, or a diamond (C) substrate.

The gallium nitride layer 22 is disposed on the substrate 21, and the gallium nitride layer 22 is preferably an undoped gallium nitride layer (if the gallium nitride layer 22 is a doped gallium nitride layer, magnesium Mg is used as a dopant).

The aluminum gallium nitride layer 23 is disposed on the gallium nitride layer 22, and the aluminum gallium nitride layer 23 is preferably an undoped aluminum gallium nitride layer.

The first dielectric layer 26 is disposed on the aluminum gallium nitride layer 23, the gate metal layer 27 is disposed on the first dielectric layer 26, the second dielectric layer 28 is disposed on the gate metal layer 27, and the second metal layer 29 is disposed on the second dielectric layer 28.

The first dielectric layer 26 separates the gate metal layer 27 from the aluminum gallium nitride layer 23. In this embodiment of this application, the first dielectric layer 26 may use a common dielectric material, a two-dimensional electron gas 211 below the aluminum gallium nitride layer 23 is connected to the second metal layer 29, and the second metal layer 29 and the gate metal layer 27 have opposite polarities, so that a first capacitor including the gate metal layer 27, the first dielectric layer 26, and the two-dimensional electron gas 211 is an inter-board capacitor (MIM). The second dielectric layer 28 separates the gate metal layer 27 from the second metal layer 29, and the second metal layer 29 and the gate metal layer 27 have opposite polarities, so that the gate metal layer 27, the second dielectric layer 28, and the second metal layer 29 form a second capacitor (MIM). The two-dimensional electron gas 211 is generated when a voltage between the gate metal layer 27 and the second metal layer 29 falls within a preset range, and a voltage usage range of a junction capacitor is 5 V to 7 V.

Optionally, an aluminum nitride layer is further included between the gallium nitride layer and the aluminum gallium nitride layer, and the two-dimensional electron gas is located between the aluminum nitride layer and the gallium nitride layer, so that electron concentration of the two-dimensional electron gas can be increased. The second metal layer passes through the second dielectric layer 28, the first dielectric layer 26, and the aluminum gallium nitride layer 23, and is in contact with the two-dimensional electron gas 211. In this case, a first terminal of the first capacitor is connected to two terminals of the second capacitor. That is, the first capacitor and the second capacitor are connected in parallel. For an equivalent circuit diagram of the integrated device, refer to FIG. 10. Alternatively, the first capacitor and the second capacitor may be connected in parallel in another connection manner, or the first capacitor and the second capacitor may be connected in series in another connection manner. This is not limited herein. In this embodiment of this application, the gate metal layer may be a positive electrode layer, and the second metal layer may be a negative electrode layer.

In this embodiment of this application, the gate metal layer, the first dielectric layer, and the two-dimensional electron gas form the first capacitor, the gate metal layer, the second dielectric layer, and the second metal layer form the second capacitor, and the two-dimensional electron gas has same potential as the second metal layer, so that the first capacitor and the second capacitor are connected in parallel, and there is no junction capacitor. This increases capacitor capacity of the integrated device, improves voltage withstand performance of the integrated device, improves capacitor integration density of the integrated device, and allows the integrated device to operate at a high voltage.

In this embodiment of this application, a quantity of capacitors in the integrated device is not limited to two to three or more capacitors. For example, the integrated device may further include one fourth dielectric layer and one fourth metal layer. This allows the integrated device to integrate one more capacitor. Alternatively, the gallium nitride layer and the aluminum gallium nitride layer may be divided into two parts, and the two-dimensional electron gas is provided by different negative electrodes, that is, the integrated device may further include another junction capacitor or inter-board capacitor. Specifically, whether the another junction or the inter-board capacitor is connected in parallel or in series in the integrated device may be determined based on a requirement, and then two terminals of the another junction or the inter-board capacitor may be connected through a conductor structure to the integrated device. This is not limited herein.

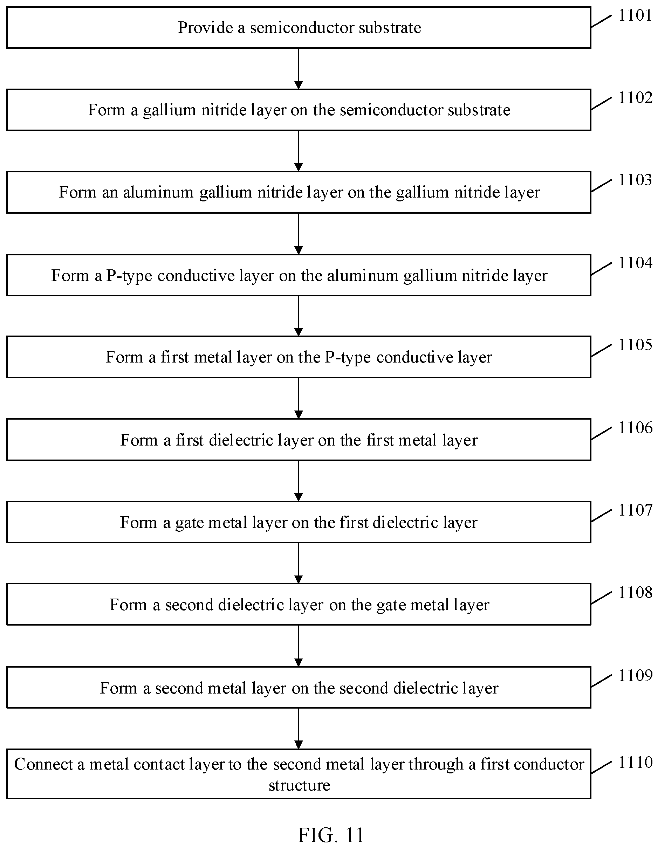

FIG. 11 is an embodiment of an integrated device manufacturing method according to an embodiment not in accordance with the present invention.

1101: Provide a substrate.

In this embodiment of this application, the substrate may be made from a silicon (Si) substrate, a sapphire (Al2O3) substrate, a silicon-on-insulator (SOI) substrate, a gallium nitride (GaN) substrate, a gallium arsenide (GaAs) substrate, an indium phosphide (InP) substrate, an aluminum nitride (AlN) substrate, a silicon carbide (SiC) substrate, a quartz (SiO2) substrate, or a diamond (C) substrate.

1102: Form a gallium nitride layer on the substrate.

In this embodiment of this application, a gallium nitride epitaxial wafer is grown on the substrate to serve as a buffer layer. The gallium nitride layer is preferably an undoped gallium nitride layer (If the gallium nitride layer is a doped gallium nitride layer, magnesium Mg is used as a dopant).

1103: Form an aluminum gallium nitride layer on the gallium nitride layer.

In this embodiment of this application, a thickness of the aluminum gallium nitride layer may be 25 nm to 35 nm. A specific forming method of the aluminum gallium nitride layer may be growing on the gallium nitride layer at a temperature about 1100°C, and the aluminum gallium nitride layer is preferably an undoped aluminum gallium nitride layer.

1104: Form a P-type conductive layer on the aluminum gallium nitride layer.

In this embodiment of this application, the P-type conductive layer is formed on an active area of the aluminum gallium nitride layer, and the P-type conductive layer is used to exhaust negative electrons in a surface state on the aluminum gallium nitride layer and neutralize a dangling bond on the aluminum gallium nitride layer. The P-type conductive layer may be P-type gallium nitride or P-type aluminum gallium nitride.

The active area of the aluminum gallium nitride layer is an area to be formed between a gate electrode, a source electrode, a drain electrode, and/or electrodes.

In one implementation, an area other than the active area is covered with a photoresist, the P-type conductive layer is formed on the active area, and then the photoresist and the P-type conductive layer outside the active area are removed. In another implementation, the P-type conductive layer is formed on the aluminum gallium nitride layer, one layer of photoresist is formed on the active area, then the P-type conductive layer outside the active area is removed, and finally the photoresist is removed. A specific forming manner may be selected according to an actual requirement. Details are not described herein again.

1105: Form a first metal layer on the P-type conductive layer.

In this embodiment of this application, the first metal layer covers only the P-type conductive layer, and the first metal layer may be titanium nitride or tungsten, to provide good conductivity. The titanium nitride is a transition metal nitride, includes a mix of an ionic bond, a metal bond, and a covalent bond, has high strength, high hardness, high temperature resistance, acid and alkali corrosion resistance, abrasion resistance, good conductivity, and good thermal conductivity, and is an excellent material for ohmic contact metal.

1106: Form a first dielectric layer on the first metal layer.

In this embodiment of this application, the first dielectric layer is formed on the first metal layer, the first dielectric layer covers both the P-type conductive layer and the aluminum gallium nitride layer, and the first dielectric layer is used to separate layers and maintain insulation between the layers.

1107: Form a gate metal layer on the first dielectric layer.

In this embodiment of this application, one layer of photoresist is covered on the first dielectric layer, the photoresist on an uncovered area at a same location as the active area of the aluminum gallium nitride layer is retained, the gate metal layer is formed on the uncovered area, and then the photoresist and the gate metal layer outside the active area are removed. Alternatively, the gate metal layer may be formed in another implementation in step 1101. Details are not described herein again.

The gate metal layer and the first metal layer have opposite polarities, and the gate metal layer and the first metal layer that are separated by the first dielectric layer form a first capacitor. In this case, the first capacitor is an inter-board capacitor.

1108: Form a second dielectric layer on the gate metal layer.

In this embodiment of this application, the second dielectric layer is formed on the gate metal layer, and the second dielectric layer covers the first dielectric layer.

1109: Form a second metal layer on the second dielectric layer.

In this embodiment of this application, the second metal layer is directly formed on the second dielectric layer, the second metal layer and the gate metal layer have opposite polarities, and the gate metal layer and the second metal layer that are separated by the second dielectric layer form a second capacitor. The second capacitor is an inter-board capacitor.

1110: Connect the first metal layer to the second metal layer through a first conductor structure.

In this embodiment of this application, the first metal layer is connected to the second metal layer through the first conductor structure, so that a first terminal of the first capacitor is interconnected with a first terminal of the second capacitor, and a second terminal of the first capacitor is interconnected with a second terminal of the second capacitor. That is, the first capacitor and the second capacitor are connected in parallel. This allows the integrated device to have a high voltage range and high capacitor density.

Optionally, a material of the first conductor structure may be copper, aluminum, or the like.

In this embodiment of this application, the first dielectric layer may separate the gate metal layer from the titanium nitride layer, the second dielectric layer separates the gate metal layer from the second metal layer, and the first metal layer is connected to the second metal layer through the first conductor structure, so that the first capacitor and the second capacitor are connected in parallel. This increases capacitor capacity of the integrated device, improves voltage withstand performance of the integrated device, and allows the integrated device to operate at a high voltage and have high capacitor density at the same time.

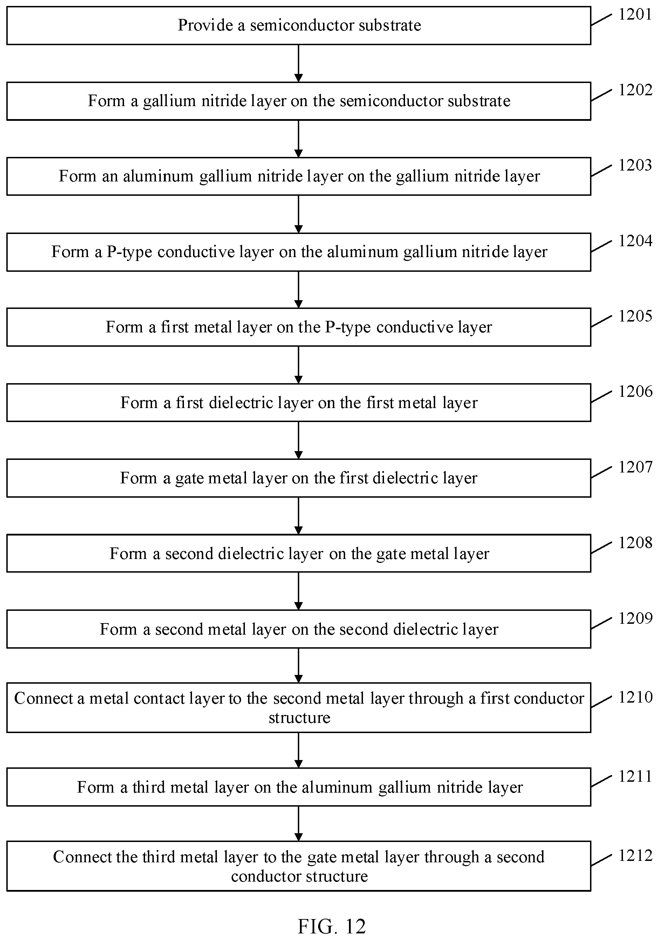

FIG. 12 is another embodiment of an integrated device manufacturing method according to an embodiment of the present invention.

1201: Provide a substrate.

1202: Form a gallium nitride layer on the substrate

1203: Form an aluminum gallium nitride layer on the gallium nitride layer.

1204: Form a P-type conductive layer on the aluminum gallium nitride layer.

1205: Form a first metal layer on the P-type conductive layer.

1206: Form a first dielectric layer on the first metal layer.

1207: Form a gate metal layer on the first dielectric layer.

1208: Form a second dielectric layer on the gate metal layer.

1209: Form a second metal layer on the second dielectric layer.

1210: Connect the first metal layer to the second metal layer through a first conductor structure.

In this embodiment of this application, for steps 1201 to 1210, refer to related descriptions of steps 1101 to 1110 in the method shown in FIG. 12. Details are not described herein again.

1211: Form a third metal layer on the aluminum gallium nitride layer.

In this embodiment of this application, the first dielectric layer outside a P-type conductive layer area, the second dielectric layer, and the aluminum gallium nitride layer may be etched until the gallium nitride layer is exposed and an etching hole is obtained. Then, the third metal layer may be formed in the etching hole, the third metal layer and the first metal layer have opposite polarities, a two-dimensional electron gas is generated below the aluminum gallium nitride layer when a voltage between the gate metal layer and the third metal layer falls within a preset range. In this case, the third metal layer is connected with the two-dimensional electron gas. That is, the two-dimensional electron gas and the first metal layer have opposite polarities.

Optionally, an aluminum nitride layer may further be provided between the aluminum gallium nitride layer and the gallium nitride layer on a gallium nitride device platform. In this case, the two-dimensional electron gas is located between the aluminum nitride layer and the gallium nitride layer, so that electron concentration of the two-dimensional electron gas can be increased.

1212: Connect the third metal layer to the gate metal layer through a second conductor structure.

In this embodiment of this application, the first metal layer, the P-type conductive layer, and the two-dimensional electron gas form a third capacitor. Because the P-type conductive layer includes P-type gallium nitride or P-type aluminum gallium nitride, the third capacitor is a junction capacitor, and the third metal layer may be connected to the gate metal layer through a second conductor structure, so that the first capacitor, the second capacitor, and the third capacitor are connected in parallel, to obtain the integrated device with higher capacitor density. Materials of the first conductor structure and the second conductor structure may be copper or aluminum.

In this embodiment of this application, the first metal layer, the P-type conductive layer, and the two-dimensional electron gas corresponding to the third metal layer form the third capacitor, and the third metal layer is connected to the gate metal layer through the second conductor structure, so that the first capacitor, the second capacitor, and the third capacitor are connected in parallel. This increases capacitor capacity of the integrated device, improves voltage withstand performance of the integrated device, and further improves capacitor integration density of the integrated device.

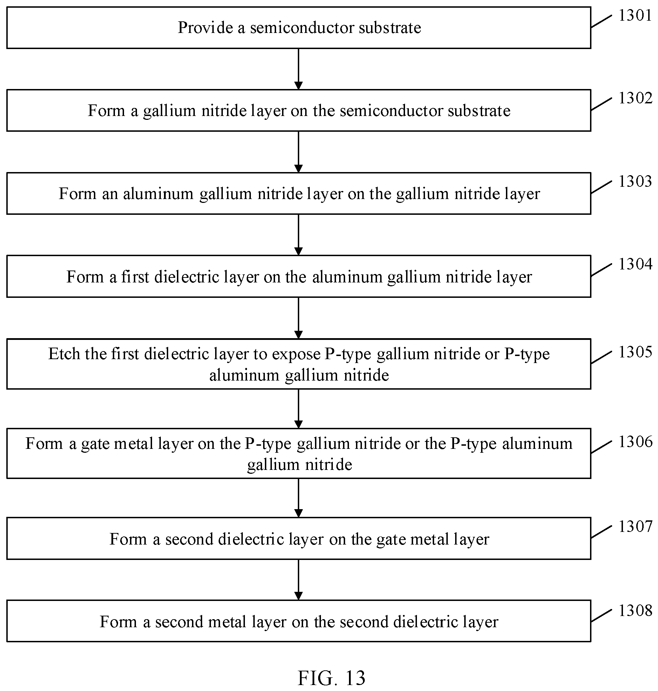

FIG. 13 is another embodiment of an integrated device manufacturing method according to an embodiment of the present invention.

1301: Provide a substrate.

1302: Form a gallium nitride layer on the substrate.

1303: Form an aluminum gallium nitride layer on the gallium nitride layer.

In this embodiment of this application, for steps 1301 to 1303, refer to related descriptions of steps 1101 to 1103 in the method shown in FIG. 11. Details are not described herein again.

1304: Form a first dielectric layer on the aluminum gallium nitride layer.

In this embodiment of this application, the first dielectric layer is formed on the aluminum gallium nitride layer, and the first dielectric layer may include P-type gallium nitride or P-type aluminum gallium nitride.

1305: Etch the first dielectric layer to expose the P-type gallium nitride or the P-type aluminum gallium nitride.

In this embodiment of this application, the first dielectric layer is etched until the P-type gallium nitride or the P-type aluminum gallium nitride in the first dielectric layer is exposed. Specifically, when titanium nitride is further disposed on the P-type gallium nitride or the P-type aluminum gallium nitride, the first dielectric layer needs to be etched until the titanium nitride is exposed.

1306: Form a gate metal layer on the P-type gallium nitride or the P-type aluminum gallium nitride.

In this embodiment of this application, the gate metal layer is formed in an etching hole obtained by etching the first dielectric layer, and the gate metal layer is connected to the P-type gallium nitride or the P-type aluminum gallium nitride. When titanium nitride is further disposed on the P-type gallium nitride or the P-type aluminum gallium nitride, the gate metal layer is connected to the titanium nitride.

1307: Form a second dielectric layer on the gate metal layer.

In this embodiment of this application, the second dielectric layer covers both the first dielectric layer and the gate metal layer.

1308: Form a second metal layer on the second dielectric layer.

In this embodiment of this application, the first dielectric layer outside a gate metal layer area, the second dielectric layer, and the aluminum gallium nitride layer may be etched, to obtain an etching hole, and the gallium nitride layer is exposed at the bottom end of the etching hole. Then, the second metal layer may be formed on the etching hole and the second dielectric layer, and the second metal layer and the gate metal layer have opposite polarities. In this case, the gate metal layer and the second metal layer that are separated by the second dielectric layer form a first capacitor, and the first capacitor is an inter-board capacitor. When a voltage between the gate metal layer and the second metal layer falls within a preset range, a two-dimensional electron gas is generated below the aluminum gallium nitride layer, the two-dimensional electron gas is connected to the second metal layer, and the gate metal layer, the first dielectric layer, and the two-dimensional electron gas together form a second capacitor (a junction capacitor). The second metal layer has same potential as the two-dimensional electron gas, so that two terminals of the first capacitor and the second capacitor are interconnected, that is, the first capacitor and the second capacitor are connected in parallel.

Optionally, an aluminum nitride layer may further be provided between the aluminum gallium nitride layer and the gallium nitride layer on a gallium nitride device platform. In this case, the two-dimensional electron gas is located between the aluminum nitride layer and the gallium nitride layer, so that electron concentration of the two-dimensional electron gas can be increased.

In this embodiment of this application, the gate metal layer may be a positive electrode layer, and the second metal layer may be a negative electrode layer. In this embodiment of this application, the gate metal layer, the first dielectric layer, and the two-dimensional electron gas form the first capacitor, the gate metal layer, the second dielectric layer, and the second metal layer form the second capacitor, and the two-dimensional electron gas is connected to the second metal layer, so that the first capacitor and the second capacitor are connected in parallel. This increases capacitor capacity of the integrated device, improves voltage withstand performance of the integrated device, and improves capacitor integration density of the integrated device.

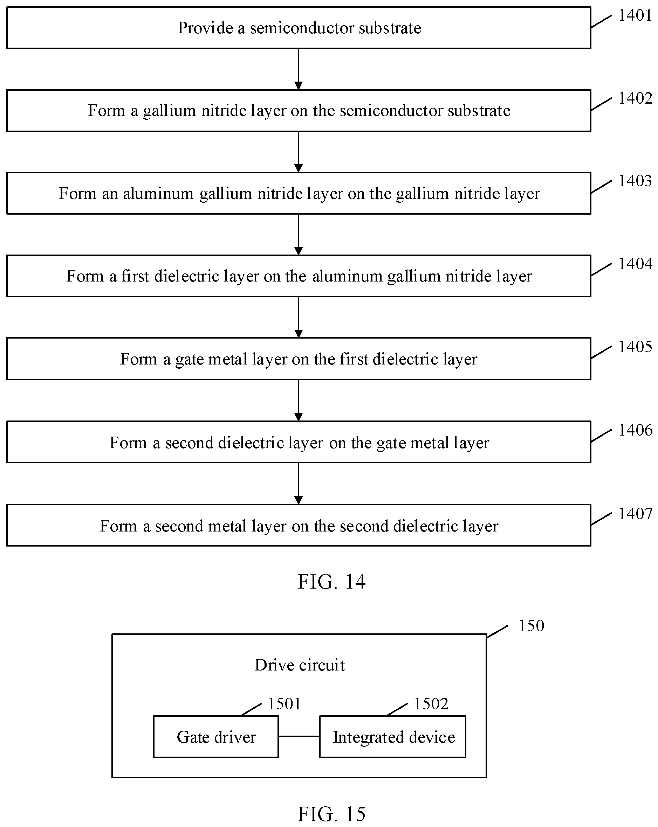

FIG. 14 is another embodiment of an integrated device manufacturing method according to an embodiment not in accordance with the present invention.

1401: Provide a substrate.

1402: Form a gallium nitride layer on the substrate.

1403: Form an aluminum gallium nitride layer on the gallium nitride layer.

In this embodiment of this application, for steps 1401 to 1403, refer to related descriptions of steps 1101 to 1103 in the method shown in FIG. 11. Details are not described herein again.

1404: Form a first dielectric layer on the aluminum gallium nitride layer.

In this embodiment of this application, the first dielectric layer covers the aluminum gallium nitride layer, a material of the first dielectric layer is a dielectric structure in an inter-board capacitor, and the first dielectric layer is used to separate different layers and insulate the layers.

1405: Form a gate metal layer on the first dielectric layer.

In this embodiment of this application, in an implementation, the gate metal layer is directly formed on the first dielectric layer, a photoresist is covered on a gate metal layer part on an active area of the aluminum gallium nitride layer, the gate metal layer that is not covered with the photoresist is removed, and then the photoresist is removed.

In another implementation, the first dielectric layer except a part above the active area of the aluminum gallium nitride layer is covered with a photoresist, the gate metal layer is formed at a location of the first dielectric layer above the active area of the aluminum gallium nitride layer, and then the photoresist and the gate metal layer outside the active area are removed.

1406: Form a second dielectric layer on the gate metal layer.

In this embodiment of this application, the second dielectric layer is directly formed on the gate metal layer, and the second dielectric layer covers both the gate metal layer and the first dielectric layer.

1407: Form a second metal layer on the second dielectric layer.

In this embodiment of this application, the first dielectric layer outside a gate metal layer area, the second dielectric layer, and the aluminum gallium nitride layer may be etched, to obtain an etching hole, and the gallium nitride layer is exposed at the bottom end of the etching hole. Then, the second metal layer may be formed on the etching hole and the second dielectric layer, and the second metal layer and the gate metal layer have opposite polarities. In this case, the gate metal layer and the second metal layer that are separated by the second dielectric layer form the first capacitor, and the first capacitor is an inter-board capacitor. When a voltage between the gate metal layer and the second metal layer falls within a preset range, a two-dimensional electron gas is generated below the aluminum gallium nitride layer, the second metal layer is connected with the two-dimensional electron gas phase, and the gate metal layer, the first dielectric layer, and the two-dimensional electron gas jointly form a second capacitor. If the first dielectric layer does not include the P-type gallium nitride or the P-type aluminum gallium nitride, the third capacitor is an inter-board capacitor.

The second metal layer has same potential as the two-dimensional electron gas, so that two terminals of the first capacitor and the second capacitor are interconnected, that is, the first capacitor and the second capacitor are connected in parallel.

Optionally, an aluminum nitride layer may further be provided between the aluminum gallium nitride layer and the gallium nitride layer on a gallium nitride device platform. In this case, the two-dimensional electron gas is located between the aluminum nitride layer and the gallium nitride layer, so that electron concentration of the two-dimensional electron gas can be increased.

In this embodiment of this application, the gate metal layer, the first dielectric layer, and the two-dimensional electron gas form the first capacitor, the gate metal layer, the second dielectric layer, and the second metal layer form the second capacitor, and the two-dimensional electron gas has same potential as the second metal layer, so that the first capacitor and the second capacitor are connected in parallel, and there is no junction capacitor. This increases capacitor capacity of the integrated device, improves voltage withstand performance of the integrated device, improves capacitor integration density of the integrated device, and allows the integrated device to operate at a high voltage.

FIG. 15 is a possible schematic diagram of a structure of a drive circuit 150 according to an embodiment of this application. The drive circuit 150 includes a gate driver 1501 and an integrated device 1502. The gate driver device 1501 may include a plurality of current sources, and one or more of the plurality of current sources may supply a current to a gate metal layer in the integrated device 1502, to change a voltage of the gate metal layer. The integrated device 1502 may be any one of the integrated devices in FIG. 2, FIG. 5, FIG. 7, and FIG. 9.

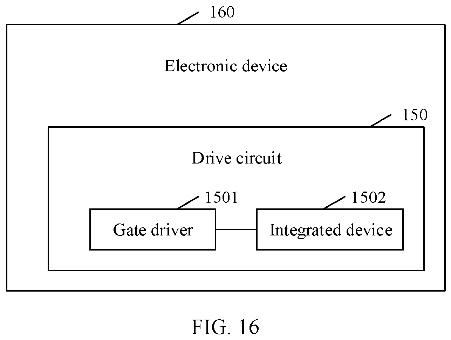

FIG. 16 is a possible schematic diagram of a structure of an electronic device 160 according to an embodiment of this application. The electronic device may be an adapter or a server. For example, the electronic device is the adapter. The adapter may include the drive circuit 150 shown in FIG. 15, that is, includes the gate driver 1501 and the integrated device 1502. The integrated device 1502 may be any one of the integrated devices in FIG. 2, FIG. 5, FIG. 7, and FIG. 9.

## Claims

1. An integrated device, comprising:
a first metal layer (25);
a first dielectric layer (26) disposed on the first metal layer;
a second dielectric layer (28) disposed on the first dielectric layer;
a gate metal layer (27) disposed between the first dielectric layer and the second dielectric layer; and
a second metal layer (29) disposed on the second dielectric layer, wherein
the first metal layer, the first dielectric layer, and the gate metal layer form a first capacitor;
the second metal layer, the second dielectric layer, and the gate metal layer form a second capacitor; and
the first metal layer is connected to the second metal layer through a first conductor structure, so that the first capacitor and the second capacitor are connected in parallel;
wherein the integrated device further comprises:
a third metal layer (210);
a P-type conductive layer (24) disposed below the first metal layer (25); and
an aluminum gallium nitride layer (23) disposed below the P-type conductive layer, on a gallium nitride layer (22);
wherein:
a two-dimensional electron gas (211) is comprised below the aluminum gallium nitride layer;
the first metal layer, the P-type conductive layer, and the two-dimensional electron gas form a third capacitor; and
the third metal layer passes through the second dielectric layer, the first dielectric layer, and the aluminum gallium nitride layer, and is in contact with the two-dimensional electron gas, and the third metal layer is connected to the gate metal layer through a second conductor structure, so that the first capacitor, the second capacitor, and the third capacitor are connected in parallel.

2. The integrated device according to claim 1, wherein an aluminum nitride layer is provided between the aluminum gallium nitride layer (23) and the gallium nitride layer (22), and the two-dimensional electron gas (211) is located below the aluminum nitride layer.

3. The integrated device according to any one of claims 1 to 2, wherein the P-type conductive layer (24) comprises P-type gallium nitride or P-type aluminum gallium nitride.

4. The integrated device according to any one of claims 1 to 2, wherein the first metal layer (25) comprises titanium nitride or tungsten.

5. The integrated device according to any one of claims 1 to 2, wherein materials of the first conductor structure and the second conductor structure comprise copper or aluminum.

6. An integrated device, comprising:
an aluminum gallium nitride layer (23) on a gallium nitride layer (22);
a first dielectric layer (26) disposed on the aluminum gallium nitride layer;
a second dielectric layer (28) disposed on the first dielectric layer;
a gate metal layer (27) disposed between the first dielectric layer and the second dielectric layer; and
a second metal layer (29) disposed on the second dielectric layer, wherein
a two-dimensional electron gas (211) is comprised below the aluminum gallium nitride layer;
the two-dimensional electron gas, the first dielectric layer, and the gate metal layer form a first capacitor;
the second metal layer, the second dielectric layer, and the gate metal layer form a second capacitor; and
the second metal layer passes through the second dielectric layer, the first dielectric layer, and the aluminum gallium nitride layer, and is in contact with the two-dimensional electron gas, so that the first capacitor and the second capacitor are connected in parallel;
wherein the first dielectric layer includes a layer (261) of P-type gallium nitride or P-type aluminum gallium nitride, and the gate metal layer passes through the first dielectric layer, and is formed on the layer of P-type gallium nitride or the P-type aluminum gallium nitride.

7. The integrated device according to claim 6, wherein an aluminum nitride layer is provided between the aluminum gallium nitride layer (23) and the gallium nitride layer (22), and the two-dimensional electron gas (211) is located below the aluminum nitride layer.

8. The integrated device according to any preceding claim, wherein the integrated device is a power amplifier.

9. A semiconductor device, comprising the integrated device according to any one of claims 1 to 8 and a semiconductor formed on the integrated device.

10. A drive circuit (150), comprising:
a gate driver (1501) and the integrated device (1502) according to any one of claims 1 to 8, wherein the gate driver is configured to supply a current to the integrated device.

11. An electronic device (160), comprising the integrated device according to any one of claims 1 to 8.

12. An electronic device according to claim 11, wherein the electronic device is an adapter.

## Patentansprüche

1. Integrierte Vorrichtung, umfassend:
eine erste Metallschicht (25);
eine erste dielektrische Schicht (26), die auf der ersten Metallschicht angeordnet ist:
eine zweite dielektrische Schicht (28), die auf der ersten dielektrischen Schicht angeordnet ist;
eine Gate-Metallschicht (27), die zwischen der ersten dielektrischen Schicht und der zweiten dielektrischen Schicht angeordnet ist; und
eine zweite Metallschicht (29), die auf der zweiten dielektrischen Schicht angeordnet ist, wobei
die erste Metallschicht, die erste dielektrische Schicht und die Gate-Metallschicht einen ersten Kondensator bilden;
die zweite Metallschicht, die zweite dielektrische Schicht und die Gate-Metallschicht einen zweiten Kondensator bilden; und
die erste Metallschicht durch eine erste Leiterstruktur mit der zweiten Metallschicht verbunden ist, so dass der erste Kondensator und der zweite Kondensator parallel geschaltet sind;
wobei die integrierte Vorrichtung ferner Folgendes umfasst:
eine dritte Metallschicht (210);
eine leitfähige Schicht (24) vom P-Typ, die unter der ersten Metallschicht (25) angeordnet ist: und
eine Aluminium-Gallium-Nitrid-Schicht (23), die unter der leitfähigen Schicht vom P-Typ auf einer Gallium-Nitrid-Schicht (22) angeordnet ist;
wobei:
sich ein zweidimensionales Elektronengas (211) unter der Aluminium-Gallium-Nitrid-Schicht befindet;
die erste Metallschicht, die leitfähige Schicht vom P-Typ und das zweidimensionale Elektronengas einen dritten Kondensator bilden; und
die dritte Metallschicht durch die zweite dielektrische Schicht, die erste dielektrische Schicht und die Aluminium-Gallium-Nitrid-Schicht hindurch verläuft und mit dem zweidimensionalen Elektronengas in Kontakt ist, und die dritte Metallschicht durch eine zweite Leiterstruktur mit der Gate-Metallschicht verbunden ist, so dass der erste Kondensator, der zweite Kondensator und der dritte Kondensator parallel geschaltet sind.

2. Integrierte Vorrichtung nach Anspruch 1, wobei eine Aluminium-Nitrid-Schicht zwischen der Aluminium-Gallium-Nitrid-Schicht (23) und der Gallium-Nitrid-Schicht (22) vorgesehen ist und sich das zweidimensionale Elektronengas (211) unter der Aluminium-Nitrid-Schicht befindet.

3. Integrierte Vorrichtung nach einem der Ansprüche 1 bis 2, wobei die leitfähige Schicht (24) vom P-Typ Gallium-Nitrid vom P-Typ oder Aluminium-Gallium-Nitrid vom P-Typ umfasst.

4. Integrierte Vorrichtung nach einem der Ansprüche 1 bis 2, wobei die erste Metallschicht (25) Titan-Nitrid oder Wolfram umfasst.

5. Integrierte Vorrichtung nach einem der Ansprüche 1 bis 2, wobei Materialien der ersten Leiterstruktur und der zweiten Leiterstruktur Kupfer oder Aluminium umfassen.

6. Integrierte Vorrichtung, umfassend:
eine Aluminium-Gallium-Nitrid-Schicht (23) auf einer Gallium-Nitrid-Schicht (22);
eine erste dielektrische Schicht (26), die auf der Aluminium-Gallium-Nitrid-Schicht angeordnet ist;
eine zweite dielektrische Schicht (28), die auf der ersten dielektrischen Schicht angeordnet ist;
eine Gate-Metallschicht (27), die zwischen der ersten dielektrischen Schicht und der zweiten dielektrischen Schicht angeordnet ist; und
eine zweite Metallschicht (29), die auf der zweiten dielektrischen Schicht angeordnet ist, wobei
ein zweidimensionales Elektronengas (211) unter der Aluminium-Gallium-Nitrid-Schicht enthalten ist;
wobei das zweidimensionale Elektronengas, die erste dielektrische Schicht und die Gate-Metallschicht einen ersten Kondensator bilden; und
die zweite Metallschicht, die zweite dielektrische Schicht und die Gate-Metallschicht einen zweiten Kondensator bilden; und
die zweite Metallschicht durch die zweite dielektrische Schicht, die erste dielektrische Schicht und die Aluminium-Gallium-Nitrid-Schicht hindurch verläuft und mit dem zweidimensionalen Elektronengas in Kontakt ist, sodass der erste Kondensator und der zweite Kondensator parallel geschaltet sind;
wobei die erste dielektrische Schicht eine Schicht (261) aus Gallium-Nitrid vom P-Typ oder Aluminium-Gallium-Nitrid vom P-Typ umfasst und die Gate-Metallschicht durch die erste dielektrische Schicht hindurch verläuft und auf der Schicht aus Gallium-Nitrid vom P-Typ oder Aluminium-Gallium-Nitrid vom P-Typ ausgebildet ist.

7. Integrierte Vorrichtung nach Anspruch 6, wobei eine Aluminium-Nitrid-Schicht zwischen der Aluminium-Gallium-Nitrid-Schicht (23) und der Gallium-Nitrid-Schicht (22) vorgesehen ist und sich das zweidimensionale Elektronengas (211) unter der Aluminium-Nitrid-Schicht befindet.

8. Integrierte Vorrichtung nach einem der vorhergehenden Ansprüche, wobei die integrierte Vorrichtung ein Leistungsverstärker ist.

9. Halbleitervorrichtung, umfassend die integrierte Vorrichtung nach einem der Ansprüche 1 bis 8 und einen Halbleiter, der auf der integrierten Vorrichtung ausgebildet ist.

10. Treiberschaltung (150), umfassend:
einen Gate-Treiber (1501) und die integrierte Vorrichtung (1502) nach einem der Ansprüche 1 bis 8, wobei der Gate-Treiber dazu ausgelegt ist, der integrierten Vorrichtung Strom zuzuführen.

11. Elektronische Vorrichtung (160), umfassend die integrierte Schaltung nach einem der Ansprüche 1 bis 8.

12. Elektronische Vorrichtung nach Anspruch 11, wobei es sich bei der elektronischen Vorrichtung um einen Adapter handelt.

## Revendications

1. Dispositif intégré comprenant :
une première couche métallique (25) ;
une première couche diélectrique (26) disposée sur la première couche métallique ;
une deuxième couche diélectrique (28) disposée sur la première couche diélectrique ;
une couche métallique de grille (27) disposée entre la première couche diélectrique et la deuxième couche diélectrique ; et
une deuxième couche métallique (29) disposée sur la deuxième couche diélectrique,
dans lequel
la première couche métallique, la première couche diélectrique et la couche métallique de grille forment un premier condensateur ;
la deuxième couche métallique, la deuxième couche diélectrique et la couche métallique de grille forment un deuxième condensateur ; et
la première couche métallique est connectée à la deuxième couche métallique par l'intermédiaire d'une première structure conductrice, de sorte que le premier condensateur et le deuxième condensateur sont connectés en parallèle ;
le dispositif intégré comprenant en outre :
une troisième couche métallique (210) ;
une couche conductrice de type P (24) disposée sous la première couche métallique (25) ; et
une couche de nitrure d'aluminium-gallium (23) disposée sous la couche conductrice de type P, sur une couche de nitrure de gallium (22) ;
dans lequel :
un gaz d'électrons bidimensionnel (211) est compris sous la couche de nitrure d'aluminium-gallium ;
la première couche métallique, la couche conductrice de type P et le gaz d'électrons bidimensionnel forment un troisième condensateur ; et
la troisième couche métallique traverse la deuxième couche diélectrique, la première couche diélectrique et la couche de nitrure d'aluminium-gallium, et est en contact avec le gaz d'électrons bidimensionnel, et la troisième couche métallique est connectée à la couche métallique de grille par l'intermédiaire d'une deuxième structure conductrice, de sorte que le premier condensateur, le deuxième condensateur et le troisième condensateur sont connectés en parallèle.

2. Dispositif intégré selon la revendication 1, dans lequel une couche de nitrure d'aluminium est pourvue entre la couche de nitrure d'aluminium-gallium (23) et la couche de nitrure de gallium (22), et le gaz d'électrons bidimensionnel (211) est situé sous la couche de nitrure d'aluminium.

3. Dispositif intégré selon l'une quelconque des revendications 1 et 2, dans lequel la couche conductrice de type P (24) comprend du nitrure de gallium de type P ou du nitrure d'aluminium-gallium de type P.

4. Dispositif intégré selon l'une quelconque des revendications 1 et 2, dans lequel la première couche métallique (25) comprend du nitrure de titane ou du tungstène.

5. Dispositif intégré selon l'une quelconque des revendications 1 et 2, dans lequel les matériaux de la première structure conductrice et de la deuxième structure conductrice comprennent du cuivre ou de l'aluminium.

6. Dispositif intégré comprenant :
une couche de nitrure d'aluminium-gallium (23) sur une couche de nitrure de gallium (22) ;
une première couche diélectrique (26) disposée sur la couche de nitrure d'aluminium-gallium ;
une deuxième couche diélectrique (28) disposée sur la première couche diélectrique ;
une couche métallique de grille (27) disposée entre la première couche diélectrique et la deuxième couche diélectrique ; et
une deuxième couche métallique (29) disposée sur la deuxième couche diélectrique,
dans lequel
un gaz d'électrons bidimensionnel (211) est compris sous la couche de nitrure d'aluminium-gallium ;
le gaz d'électrons bidimensionnel, la première couche diélectrique et la couche métallique de grille forment un premier condensateur ;
la deuxième couche métallique, la deuxième couche diélectrique et la couche métallique de grille forment un deuxième condensateur ; et
la deuxième couche métallique traverse la deuxième couche diélectrique, la première couche diélectrique et la couche de nitrure d'aluminium-gallium, et est en contact avec le gaz d'électrons bidimensionnel, de sorte que le premier condensateur et le deuxième condensateur sont connectés en parallèle ;
dans lequel la première couche diélectrique comprend une couche (261) de nitrure de gallium de type P ou de nitrure d'aluminium-gallium de type P, et la couche métallique de grille traverse la première couche diélectrique et est formée sur la couche de nitrure de gallium de type P ou de nitrure d'aluminium-gallium de type P.

7. Dispositif intégré selon la revendication 6, dans lequel une couche de nitrure d'aluminium est pourvue entre la couche de nitrure d'aluminium-gallium (23) et la couche de nitrure de gallium (22), et le gaz d'électrons bidimensionnel (211) est situé sous la couche de nitrure d'aluminium.

8. Dispositif intégré selon l'une quelconque des revendications précédentes, dans lequel le dispositif intégré est un amplificateur de puissance.

9. Dispositif à semi-conducteur, comprenant le dispositif intégré selon l'une quelconque des revendications 1 à 8 et un semi-conducteur formé sur le dispositif intégré.

10. Circuit d'attaque (150) comprenant :
un circuit d'attaque de grille (1501) et le dispositif intégré (1502) selon l'une quelconque des revendications 1 à 8, le circuit d'attaque de grille étant configuré pour fournir un courant au dispositif intégré.

11. Dispositif électronique (160) comprenant le dispositif intégré selon l'une quelconque des revendications 1 à 8.

12. Dispositif électronique selon la revendication 11, dans lequel le dispositif électronique est un adaptateur.
